# FASCICULE DE BREVET EUROPEEN

(11) **EP 2 779 335 B1**
(45) Date de publication et mention de la délivrance du brevet: **06.04.2016**
(21) Numéro de dépôt: 14155366.9
(22) Date de dépôt: 17.02.2014
(51) Int. Cl.: H02B 1/56

(54) **Armoire électrique à dissipation thermique améliorée**
Schaltschrank mit verbesserter Wärmeableitung
Electrical cabinet with improved heat dissipation

(30) Priorité: 12.03.2013 FR 1352177
(43) Date de publication de la demande: 17.09.2014
(73) Titulaire: Schneider Electric Industries SAS, 92500 Rueil-Malmaison (FR)
(72) Inventeur: Agnaou, Abderrahmane, 38050 GRENOBLE Cedex 09 (FR); Wasner, Olivier, 38050 GRENOBLE Cedex 09 (FR); Perrin, Alain, 38050 GRENOBLE Cedex 09 (FR); Socquet, Dominique, 38050 GRENOBLE Cedex 09 (FR); Laye, Jérôme, 38050 GRENOBLE Cedex 09 (FR); Lepretre, Pascal, 38050 GRENOBLE Cedex 09 (FR)
(74) Mandataire: Tripodi, Paul

(56) Documents cités:
- DE-A1- 19 728 306
- US-A- 3 364 838
- US-A- 6 164 369
- US-B1- 6 341 064

## Description

### DOMAINE TECHNIQUE DE L'INVENTION

L'invention est relative à une armoire électrique à dissipation thermique améliorée. L'armoire électrique comportant une partie avant et une partie arrière est destinée à recevoir des unités fonctionnelles électriques comportant chacune des appareils électriques. Ladite armoire électrique comprend également une paroi de séparation délimitant une première zone thermique froide et une seconde zone thermique d'échauffement. La première zone est formée par un premier espace situé vers la partie avant de l'armoire, ladite zone froide étant destinée à recevoir des appareils électriques ou parties d'appareils qui ne chauffent pas ou très peu. La seconde zone thermique est formée par un deuxième espace situé vers la partie arrière de l'armoire, ladite zone chaude étant destinée à recevoir des appareils ou parties d'appareils qui chauffent.

### ETAT DE LA TECHNIQUE ANTERIEURE

Il est connu d'installer tous les équipements électriques sur un châssis fixé à l'arrière d'une armoire électrique. Le refroidissement se fait alors de manière traditionnelle par l'avant vers les équipements. Compte tenu que tous les équipements sont installés sur un même châssis en fond d'armoire, les équipements qui dissipent beaucoup de chaleur sont alors mélangés avec ceux qui ne dissipent pas beaucoup. En outre, les équipements peu sensibles à la chaleur et pouvant fonctionner à des températures élevées sont ainsi mélangés avec des équipements très sensibles. Ce type d'installation implique un système de refroidissement commun de puissance élevée. Les consommations énergétiques utiles pour ce type d'installation sont ainsi importantes pour assurer un froid qui n'est pas nécessaire pour tous les équipements. En outre, plus les systèmes ou équipements de production de froid sont de forte puissance, plus les risques de colmatage des systèmes de filtration sont forts.

Il est connu du document référencé DE102009054011 A1 une armoire électrique proposant une solution pour améliorer le refroidissement des appareils électriques logés dans l'armoire électrique. Cette solution consiste :
- à séparer l'armoire en deux espaces, un premier espace situé vers l'avant, comportant des appareils électriques à refroidir, et un deuxième espace situé vers l'arrière et comportant une arrivée d'air froid venant de l'extérieur et un système de ventilation permettant de faire circuler efficacement cet air froid venant de l'extérieur et,
- à réaliser des ouvertures entre les différents appareils électriques pour permettre au flux d'air froid de passer du deuxième espace vers le premier espace et de balayer tous les appareils électriques. Les ouvertures sont par exemple prolongées par des goulottes afin d'amener le flux d'air au plus proche de la zone de l'appareil électrique à refroidir.

Dans cette solution, toutes les parties des appareils électriques sont destinées à être à une même température alors que tous les appareils électriques ne nécessitent pas forcément le même niveau de refroidissement. De plus cette solution n'est pas adaptée à un ensemble d'installation comportant des armoires qui sont juxtaposées ou fixées contre un mur ou un bâti (non accessibilité de l'armoire par l'arrière).

Les documents DE19728306 et US56341064 décrivent des armoires ayant deux zones de refroidissement différentes.

### EXPOSE DE L'INVENTION

L'invention vise donc à remédier aux inconvénients de l'état de la technique, de manière à proposer une armoire électrique ayant une architecture thermique optimisée grâce à une répartition intelligente des sources de chaleur et des systèmes de dissipation.

L'armoire électrique selon l'invention comporte un dispositif de refroidissement et de régulation de la température des premier et second espaces. Ledit dispositif comprenant une source de refroidissement positionnée au contact du premier espace pour le refroidir et des moyens d'échange thermique autorisant le passage de froid entre le premier espace et le second espace pour refroidir la seconde zone thermique d'échauffement à partir de la première zone thermique froide.

De préférence, les moyens d'échange thermique sont positionnés sur la paroi de séparation.

Selon un mode de développement de l'invention, les moyens d'échange thermique sont actifs et régulés de manière à transférer du froid en fonction d'une température de consigne fixée dans le second espace.

De préférence, les moyens d'échange thermique régulés comportent au moins un actionneur commandé et relié à une unité de traitement, ledit actionneur étant apte à faire circuler le flux d'air du premier espace vers le second espace.

Selon un mode de réalisation de l'invention, la source de refroidissement au contact du premier espace est positionnée sur une face de l'armoire électrique.

Avantageusement, le volume du premier espace est modulable.

De préférence, l'armoire électrique comporte des moyens de fixation agencés pour recevoir des unités fonctionnelles électriques, lesdites unités formant la paroi de séparation.

De préférence, les unités fonctionnelles électriques comportent chacune un support supportant plusieurs appareils électriques.

De préférence, une unité fonctionnelle électrique comporte un appareil électrique traversant la paroi de séparation de manière à disposer d'une première partie située dans le premier espace et d'une deuxième partie située dans le second espace.

Avantageusement, la deuxième partie de l'appareil électrique comporte un système de ventilation dans le second espace.

### BREVE DESCRIPTION DES FIGURES

D'autres avantages et caractéristiques ressortiront plus clairement de la description qui va suivre de modes particuliers de réalisation de l'invention, donnés à titre d'exemples non limitatifs, et représentés aux dessins annexés sur lesquels :
- la figure 1 représente, vu de côté, l'intérieur de l'armoire électrique selon un premier mode préférentiel de réalisation de l'invention ;

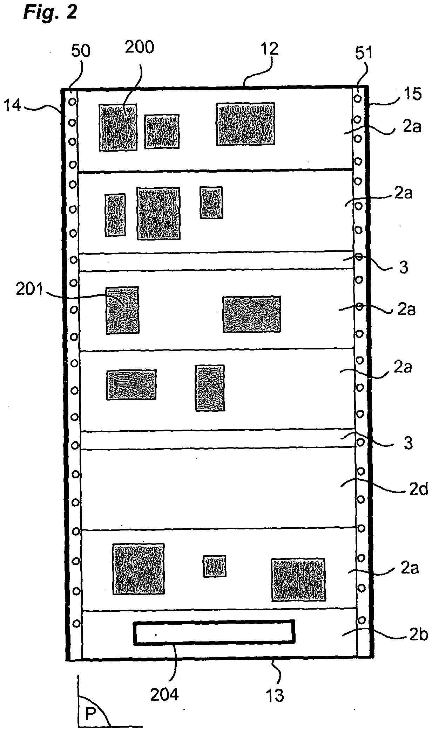

- la figure 2 représente, vu de face, l'intérieur de l'armoire électrique selon la figure 1 ;
- la figure 3 représente, vu de côté, une variante de réalisation de l'armoire électrique selon la figure 1 ;
- La figure 4 représente, vu de coté, une autre variante de réalisation de l'armoire électrique selon la figure 1 ;

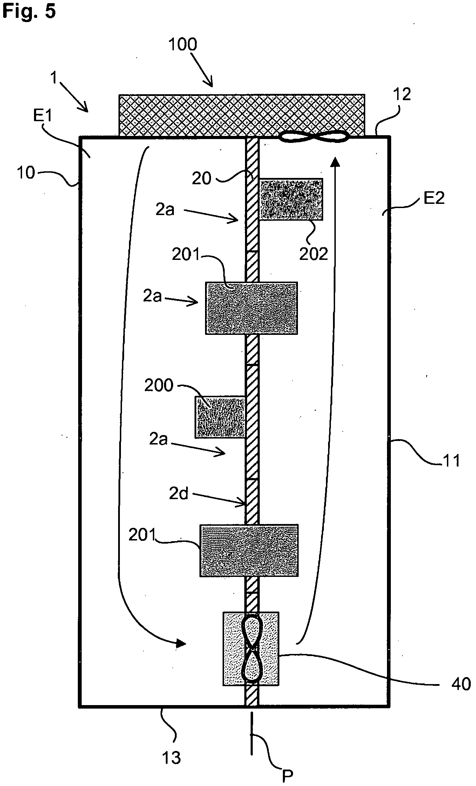

- La figure 5 représente, vu de côté une autre variante de réalisation de l'armoire électrique qui ne fait pas partie de l'invention.

### DESCRIPTION DETAILLEE D'UN MODE DE REALISATION

L'invention concerne une armoire électrique 1. L'armoire électrique 1 est préférentiellement de forme parallélépipédique. Bien entendu, une armoire cylindrique à section circulaire ou ayant une section d'une forme différente pourrait tout à fait être envisagée. Ce principe s'applique aussi à tout tableau électrique dont l'enveloppe de protection est réalisée par le bâti de l'équipement avec des formes complexes. Dans la suite de la description, on s'intéressera à une armoire électrique de forme parallélépipédique. L'armoire électrique comporte ainsi une paroi avant 10, une paroi arrière 11, une paroi supérieure 12, une paroi inférieure 13 et deux parois latérales.

La paroi avant 10 de l'armoire électrique 1 comporte par exemple une porte d'accès à l'intérieur de l'armoire.

L'armoire électrique 1 de l'invention pourra notamment être étanche, par exemple conforme à la norme IEC 60529 avec un indice IP55. La solution de dissipation thermique décrite ci-dessous est parfaitement adaptée pour refroidir des appareils électriques logés dans une armoire électrique étanche de ce type mais il faut comprendre qu'elle peut s'adapter à une armoire non étanche ou d'un niveau d'étanchéité différent.

A l'intérieur, l'armoire électrique selon l'invention comporte une paroi de séparation 20 entre un premier espace E1 situé vers la partie avant de l'armoire électrique 1 et un deuxième espace E2 situé vers la partie arrière de l'armoire électrique 1. La paroi de séparation 20 est de préférence parallèle aux parois avant 10 et arrière 11 de l'armoire électrique 1.

Selon l'invention, du fait de la présence de la paroi de séparation 20, le volume intérieur de l'armoire électrique 1 est divisé en deux zones thermiques distinctes :
- une première zone froide formée par le premier espace E1 car elle est destinée à recevoir des appareils électriques ou parties d'appareils qui ne chauffent pas ou très peu. En outre, ces appareils sont généralement sensibles à la chaleur et tendent à fonctionner de façon optimale quand la température est limitée.
- une seconde zone chaude formée par le deuxième espace E2 car elle est destinée à recevoir des appareils ou parties d'appareils qui chauffent. En outre, ces appareils sont généralement peu sensibles à la chaleur et tendent à fonctionner de façon optimale même si la température est plus élevée.

Préférentiellement, le premier espace E1 peut être modulé pour adapter son volume aux contraintes d'implantation des appareils et aux contraintes thermiques.

Selon un mode préférentiel de réalisation de l'invention, l'armoire électrique comporte un dispositif de refroidissement et de régulation de la température des premier et second espaces E1, E2. Le dispositif de refroidissement et de régulation est destiné :
- d'une part à fixer et à réguler une première température de fonctionnement T1 à l'intérieur du premier espace E1 ;
- d'autre part à fixer et à réguler une seconde température de fonctionnement T2 dans le second espace E2.

La seconde température de fonctionnement T2 est supérieure à la première température de fonctionnement T1.

Selon un mode préférentiel de réalisation de l'invention, le dispositif de refroidissement et de régulation comporte une source de refroidissement 100 et des moyens d'échange thermique 40 régulés.

La source de refroidissement 100 est positionnée au contact du premier espace E1 pour le refroidir. On entend par « être au contact » du premier espace E1, le fait que le froid produit par ladite source de refroidissement 100 est destiné à refroidir ledit premier espace.

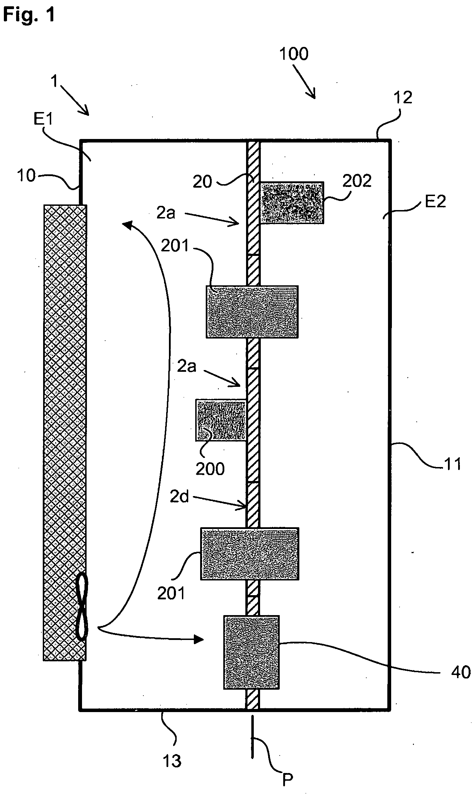

Selon sa position sur l'armoire électrique 1, la source de refroidissement 100 est agencée pour extraire de l'air présent dans le premier espace E1, refroidir cet air et réinjecter l'air refroidi dans le premier espace E1 (figure 1).

Selon un premier exemple de réalisation représenté sur la figure 1, la source de refroidissement 100 est fixée sur la paroi avant 10 de l'armoire. A titre d'exemple, la source de refroidissement 100 comporte un groupe de climatisation fixé sur la porte d'accès de l'armoire.

En variante de réalisation, la source de refroidissement 100, par exemple le groupe de climatisation, est fixée sur l'une des deux parois latérales de l'armoire électrique.

Selon un second exemple de réalisation non représenté, la source de refroidissement 100 est positionnée à proximité du premier espace E1 de manière à ce qu'un conduit de ventilation relie directement ladite source de refroidissement à la première zone froide formée par le premier espace E1.

A titre d'exemple, la source de refroidissement comporte un groupe de climatisation fixé sur la porte d'accès de l'armoire. Afin de prendre en compte les contraintes d'installation de l'armoire électrique, l'évacuation des calories peut s'effectuer par une ou plusieurs faces de l'armoire.

Selon l'invention, le dispositif de refroidissement et de régulation comporte des moyens d'échange thermique 40. Les moyens d'échange thermique 40 sont aptes à transférer du froid du premier espace E1 vers le second espace E2. A titre d'exemple de fonctionnement, la première température T1 de fonctionnement de la zone froide du premier espace E1 est régulée à une température de 35°C. La zone chaude est refroidie grâce à un ou plusieurs moyens d'échange thermique 40. Ces moyens permettent de transférer le froid strictement nécessaire à la zone chaude pour assurer une seconde température T2 de fonctionnement la plus critique (celle de l'appareil le plus sensible), par exemple à 50°C.

Selon l'invention, les moyens d'échange thermique 40 sont actifs et régulés de manière à transférer du froid en fonction d'une température de consigne fixée dans le second espace E2. Les moyens d'échange thermique 40 régulés 40 comportent de préférence au moins un actionneur commandé et relié à une unité de traitement (non représentée). L'unité de traitement est apte à agir sur l'actionneur des moyens d'échange thermique régulés 40 en fonction de la seconde température de fonctionnement T2 mesurée dans le second espace E2. Les moyens d'échange thermique régulés 40 comportent de préférence un thermostat installé par exemple au milieu de la zone chaude au 2/3 de la hauteur et relié à l'actionneur Si le thermostat mesure une seconde température de fonctionnement T2 supérieure à une consigne (par exemple 50°C), l'unité de traitement déclenche l'actionneur afin de transférer du froid vers la zone chaude. Selon un premier exemple de réalisation, l'actionneur comporte de préférence un ventilateur positionné sur la paroi de séparation 20. Selon un autre exemple de réalisation, l'actionneur des moyens d'échange thermique régulés 40 comporte un orifice associé à un volet basculant commandé à l'ouverture et/ou la fermeture. L'orifice et le volet sont positionnés sur la paroi de séparation 20. Le volet est avantageusement réalisé pour orienter le flux d'air frais vers le haut du coté de l'espace E2 afin de favoriser la transmission du flux d'air plus frais vers les points chauds. Il pourra être positionné à différente hauteur sur la paroi 20 afin de commencer à refroidir de façon préférentielle un équipement particulier.

Selon un mode de développement préférentiel de l'invention, la paroi de séparation 20 entre les premier et second espaces E1, E2 comporte plusieurs unités fonctionnelles 2a, 2b amovibles comportant respectivement un support adapté pour se fixer sur des moyens de fixation par exemple constitués de deux montants 50, 51 verticaux parallèles. Selon cet exemple de réalisation, les deux montants verticaux sont positionnés dans un plan, dit plan de séparation P, qui est par exemple parallèle aux parois avant 10 et arrière 11 de l'armoire électrique 1. Selon l'invention, chaque support d'unité fonctionnelle fixée, de manière amovible, sur les moyens de fixation présente deux faces parallèles au plan de séparation P, une face avant située du côté du premier espace E1 et une face arrière située du côté du second espace E2. Un ensemble d'unités fonctionnelles 2a, 2b placées au niveau du plan de séparation P est par exemple agencé pour former la paroi de séparation 20.

Les unités fonctionnelles 2a, 2b sont positionnées de manière adjacente suivant le plan de séparation P de manière à former la paroi de séparation 20. Cette paroi de séparation peut être nativement isolante ou le devenir avec l'adjonction d'isolant thermique lorsque la puissance dissipée par les appareils dans le seconde espace E2 est beaucoup plus importante que la puissance dissipée dans le premier espace E1. Des unités fonctionnelles d'obturation 2d (figure 1), ne portant aucun appareil ou élément, peuvent également être prévues pour réaliser la paroi de séparation 20 complète sur toute la hauteur de l'armoire électrique 1. Bien entendu, pour faire varier les volumes des deux espaces E1, E2, la position en profondeur des montants, et donc de la paroi de séparation, peut être adaptée.

Les unités fonctionnelles peuvent être notamment des unités fonctionnelles électriques 2a, des unités fonctionnelles de ventilation 2b et/ou des unités fonctionnelles de refroidissement (non illustrées). Ces unités fonctionnelles sont combinées dans l'armoire en tenant compte des applications à commander ou contrôler et de différentes contraintes, notamment thermiques. Chaque unité fonctionnelle peut remplir par exemple des fonctions de contrôle-commande, de ventilation ou de refroidissement. On entend par unité fonctionnelle électrique 2a, une unité fonctionnelle qui comporte un ou plusieurs appareils électriques, tels que par exemple un disjoncteur, un contacteur électromécanique, un départ-moteur, un variateur de vitesse, un démarreur, un filtre ou une résistance de freinage, des composants d'automatismes tels que des automates, des modules d'entrées sorties et/ou des ilots de communication. Des appareils électriques de ce type sont par exemple rassemblés dans une unité fonctionnelle électrique 2a selon leur fonction et/ou leurs caractéristiques thermiques.

Certaines unités fonctionnelles électriques 2a comportent des appareils électriques de contrôle/commande 200 ne comportant pas de système de dissipation thermique embarqué mais tout en étant sensibles à la température. Ainsi, comme représenté sur la figure 1, lesdits appareils électriques sont alors placés dans le premier espace E1.

D'autres unités fonctionnelles électriques peuvent comporter des appareils électriques de puissance 201 qui sont susceptibles de beaucoup chauffer et qu'il est donc nécessaire de refroidir.

En référence à la figure 1, selon le type d'appareil électrique employé sur les unités fonctionnelles électriques 2a, divers agencements sont possibles :
Certains appareils électriques seront entièrement situés dans le premier espace E1, c'est-à-dire fixés sur la face avant du support de l'unité fonctionnelle électrique 2a. Ces appareils électriques présents dans le premier espace E1 sont par exemple des appareils de contrôle-commande 200 tels que des disjoncteurs ou des contacteurs électromécaniques, automates...
Certains appareils électriques seront situés uniquement dans le deuxième espace E2, c'est-à-dire fixés sur la face arrière du support de l'unité fonctionnelle électrique 2a. Ces appareils électriques 202 présents uniquement dans le deuxième espace E2 sont par exemple des inductances de lissage ou des résistances de freinage, des transformateurs ou autres composants passifs. D'autres systèmes pouvant dissiper des calories tel que, système de distribution électrique de puissance par exemple sont implantés dans la zone E2.

Sur une unité fonctionnelle il est possible d'implanter des appareils sur les deux faces, de sensibilité différente destinés à être mis sur la zone E1 ou E2.

Certains appareils électriques pourront traverser leur support de manière à présenter une première partie située dans le premier espace E1 et une deuxième partie située dans le deuxième espace E2. Ces appareils électriques situés en partie dans le premier espace et dans le deuxième espace E2 sont par exemple des appareils dissipateur de puissance 201 du type variateur de vitesse, démarreur progressif, alimentation, contrôleur de mouvement, onduleur... La partie contrôle de ces appareils est située à l'avant et la partie puissance dotée des transistors de puissance située à l'arrière. La partie puissance pourra notamment comporter un système de ventilation intégré.

Dans une configuration particulière non représentée, des ouvertures sont distribuées entre certaines unités fonctionnelles pour faire communiquer le premier espace E1 avec le deuxième espace E2. Un flux d'air peut ainsi circuler de la zone froide vers la zone d'échauffement par une ou plusieurs ouvertures.

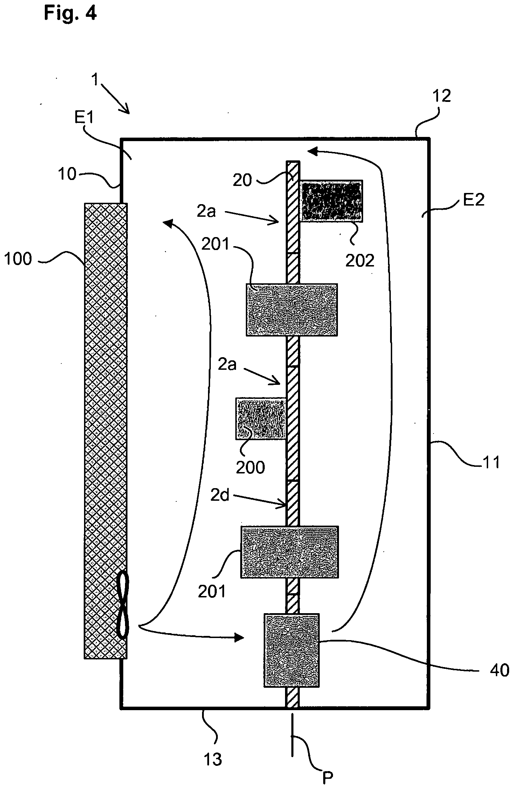

Inversement, tel que représenté sur la figure 4, il peut y avoir des ouvertures en haut de l'armoire, pour faire circuler l'air de la zone chaude vers la zone froide par retour de flux produit par le moyen d'échange thermique 40 par exemple à l'aide d'un ventilateur de transfert. Ce ventilateur met sous pression la partie chaude, et cette ouverture permet la détente (circulation d'air contrôlée).

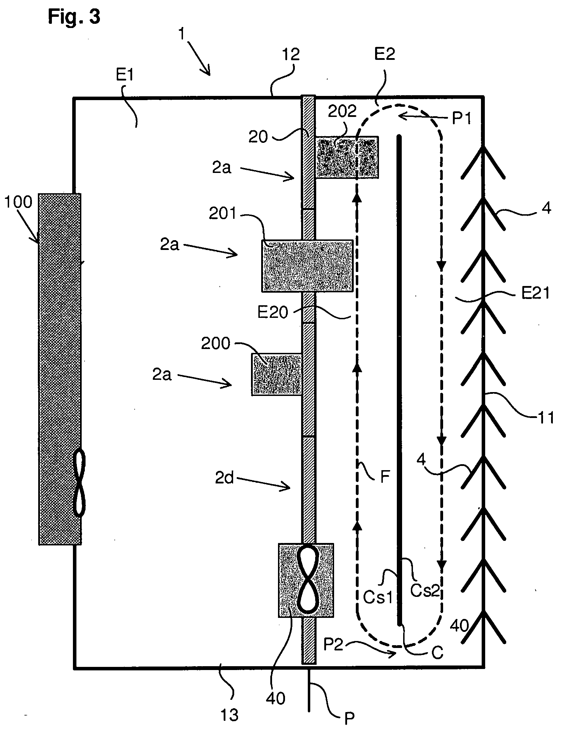

Selon une variante de réalisation de l'invention telle que représentée sur la figure 3, l'armoire électrique 1 comporte également, dans le deuxième espace E2, une cloison C s'étendant suivant un plan vertical parallèle au plan de séparation P. Cette cloison C permet ainsi de diviser le deuxième espace E2 en un premier sous-espace E20 situé vers la partie avant de l'armoire électrique 1 et un deuxième sous-espace E21 situé vers la partie arrière de l'armoire électrique 1. La position de cette cloison est ajustable en profondeur pour pouvoir faire varier les volumes des deux sous-espaces E20, E21. Cette cloison C est fixée à l'intérieur de l'armoire électrique 1 de manière à laisser au moins deux passages P1, P2 permettant à un flux d'air de circuler entre le premier sous-espace E20 et le deuxième sous-espace E21. Préférentiellement, un premier passage P1 est réalisé en haut de l'armoire électrique 1 et un deuxième passage P2 est réalisé dans le bas de l'armoire électrique. La cloison C comporte une face avant Cs1 située du côté du premier sous-espace E20 du deuxième espace et une face arrière Cs2 située du côté du deuxième sous-espace E21 du deuxième espace. La position de la cloison C est également ajustable en hauteur de manière à pouvoir faire varier la taille des passages P1, P2.

Selon une variante de réalisation de l'invention, l'armoire électrique 1 peut être équipée de matériaux de différentes conductivités thermiques sur la partie de du deuxième espace E2. Le choix se fera en fonction de la température extérieure de l'armoire. Les parois pourront comporter des ailettes d'échange thermique 4 de manière à augmenter la surface d'échange thermique A titre d'exemple, des ailettes d'échange thermique peuvent ainsi être positionnées sur la paroi arrière 11 de l'armoire électrique 1, sur la face externe de celle-ci et/ou sur la face interne de celle-ci.

Selon l'invention, les différentes caractéristiques de l'armoire électrique 1 présentées ci-dessus dans les différentes configurations représentées sur les figures peuvent tout à fait être combinées entre elles pour s'adapter aux appareils électriques logés dans l'armoire électrique, à la situation et à l'environnement de l'armoire électrique.

## Revendications

1. Armoire électrique (1) comportant une partie avant et une partie arrière, et destinée à recevoir des unités fonctionnelles électriques (2a, 2b) amovibles comportant chacune des appareils électriques (200, 201, 202), ladite armoire électrique (1) comprenant également :
- une paroi de séparation (20) délimitant :
- une première zone thermique froide formée par un premier espace (E1) situé vers la partie avant de l'armoire, ladite zone froide étant destinée à recevoir des appareils électriques ou parties d'appareils qui ne chauffent pas ou très peu, et
- une seconde zone thermique d'échauffement formée par un deuxième espace (E2) situé vers la partie arrière de l'armoire, ladite zone chaude étant destinée à recevoir des appareils ou parties d'appareils qui chauffent,
- les unités fonctionnelles (2a, 2b) amovibles forment ladite paroi de séparation,
- l'armoire électrique (1) comporte un dispositif de refroidissement et de régulation de la température des premier et second espaces E1, E2, **caractérisée en ce que** ledit dispositif comprenant :
- une source de refroidissement (100) positionnée uniquement au contact du premier espace (E1) pour le refroidir ;
- des moyens d'échange thermique (40) autorisant le passage de froid entre le premier espace (E1) et le second espace (E2) pour refroidir la seconde zone thermique d'échauffement à partir de la première zone thermique froide, les moyens d'échange thermique (40) étant actifs et régulés de manière à transférer du froid en fonction d'une température de consigne fixée dans le second espace (E2).

2. Armoire électrique selon la revendication 1, **caractérisée en ce que** les moyens d'échange thermique (40) sont positionnés sur la paroi de séparation (20).

3. Armoire électrique selon la revendication 1, **caractérisée en ce que** les moyens d'échange thermique (40) régulés comportent au moins un actionneur commandé et relié à une unité de traitement, ledit actionneur étant apte à faire circuler le flux d'air du premier espace (E1) vers le second espace (E2).

4. Armoire électrique selon l'une quelconque des revendications précédentes, **caractérisée en ce que** la source de refroidissement (100) au contact du premier espace (E1) est positionnée sur une face de l'armoire électrique (1).

5. Armoire électrique selon l'une quelconque des revendications précédentes, **caractérisée en ce que** le volume du premier espace (E1) est modulable

6. Armoire électrique selon l'une quelconque des revendications précédentes, **caractérisée en ce qu**'elle comporte des moyens de fixation agencés pour recevoir des unités fonctionnelles électriques, lesdites unités formant la paroi de séparation (20).

7. Armoire électrique selon l'une quelconque des revendications précédentes, **caractérisée en ce que** les unités fonctionnelles électriques (2a) comportent chacune un support supportant plusieurs appareils électriques (200, 201, 202).

8. Armoire électrique selon l'une quelconque des revendications précédentes, **caractérisée en ce qu'**une unité fonctionnelle électrique (2a) comporte un appareil électrique (201) traversant la paroi de séparation (20) de manière à disposer d'une première partie située dans le premier espace (E1) et d'une deuxième partie située dans le second espace (E2).

9. Armoire électrique selon la revendication précédente, **caractérisée en ce que** la deuxième partie de l'appareil électrique (201) comporte un système de ventilation dans le second espace (E2).

## Patentansprüche

1. Schaltschrank (1), der einen vorderen Teil und einen hinteren Teil aufweist und dazu bestimmt ist, abnehmbare elektrische Funktionseinheiten (2a, 2b) aufzunehmen, die jeweils elektrische Geräte (200, 201, 202) aufweisen, wobei der Schaltschrank (1) ebenfalls Folgendes aufweist:
- eine Trennwand (20), die Folgendes begrenzt:
- einen kalten, ersten thermischen Bereich, der durch einen ersten Raum (E1) gebildet ist, der in Richtung des vorderen Teils des Schranks angeordnet ist, wobei der kalte Bereich dazu bestimmt ist, elektrische Geräte oder Teile von Geräten aufzunehmen, die sich nicht oder nur sehr wenig erwärmen, und
- einen zweiten thermischen Bereich des Erwärmens, der durch einen zweiten Raum (E2) gebildet ist, der in Richtung des hinteren Teils des Schranks angeordnet ist, wobei der warme Bereich dazu bestimmt ist, elektrische Geräte oder Teile von Geräten aufzunehmen, die sich erwärmen,
- abnehmbare Funktionseinheiten (2a, 2b), die die Trennwand bilden,
- wobei der elektrische Schaltschrank (1) eine Vorrichtung zum Kühlen und zur Regelung der Temperatur des ersten und zweiten Raums E1, E2 aufweist, **dadurch gekennzeichnet, dass** die Vorrichtung Folgendes aufweist:
- eine Kühlquelle (100), die nur in Kontakt mit dem ersten Raum (E1) angeordnet ist, um ihn zu kühlen;
- Wärmeaustauschmittel (40), die den Durchgang von Kälte zwischen dem ersten Raum (E1) und dem zweiten Raum (E2) gestatten, um den zweiten thermischen Bereich des Erwärmens ausgehend von dem kalten, ersten thermischen Bereich zu kühlen, wobei die Wärmeaustauschmittel (40) aktiv sind und derart reguliert werden, um Kälte in Abhängigkeit von einer festgelegten Solltemperartur in den zweiten Raum (E2) zu übertragen.

2. Schaltschrank nach Anspruch 1, **dadurch gekennzeichnet, dass** diese Wärmeaustauschmittel (40) auf der Trennwand (20) angeordnet sind.

3. Schaltschrank nach Anspruch 1, **dadurch gekennzeichnet, dass** die regulierten Wärmeaustauschmittel (40) mindestens einen Aktuator aufweisen, der gesteuert und mit einer Verarbeitungseinheit verbunden ist, wobei der Aktuator geeignet ist, den Luftstrom von dem ersten Raum (E1) zu dem zweiten Raum (E2) zirkulieren zu lassen.

4. Schaltschrank nach einem der vorhergehenden Ansprüche, **dadurch gekennzeichnet, dass** die Kühlquelle (100) in Kontakt mit dem ersten Raum (E1) auf einer Seite des Schaltschranks (1) angeordnet ist.

5. Schaltschrank nach einem der vorhergehenden Ansprüche, **dadurch gekennzeichnet, dass** das Volumen des ersten Raums (E1) veränderbar ist.

6. Schaltschrank nach einem der vorhergehenden Ansprüche, **dadurch gekennzeichnet, dass** er Befestigungsmittel aufweist, die angeordnet sind, um elektrische Funktionseinheiten aufzunehmen, wobei die Einheiten die Trennwand (20) bilden.

7. Schaltschrank nach einem der vorhergehenden Ansprüche, **dadurch gekennzeichnet, dass** die elektrischen Funktionseinheiten (2a) jeweils einen Träger aufweisen, der mehrere elektrische Geräte (200, 201, 202) trägt.

8. Schaltschrank nach einem der vorhergehenden Ansprüche, **dadurch gekennzeichnet, dass** eine elektrische Funktionseinheit (2a) ein elektrisches Gerät (201) aufweist, das die Trennwand (20) derart durchquert, um über einen ersten Teil, der in dem ersten Raum (E1) angeordnet ist, und einen zweiten Teil, der in dem zweiten Raum (E2) angeordnet ist, zu verfügen.

9. Schaltschrank nach einem der vorhergehenden Ansprüche, **dadurch gekennzeichnet, dass** der zweite Teil des elektrischen Geräts (201) ein Belüftungssystem in dem zweiten Raum (E2) aufweist.

## Claims

1. Electrical enclosure (1) comprising a front part and a rear part and intended to receive removable functional electrical units (2a, 2b) each comprising electrical devices (200, 201, 202), the said electrical enclosure (1) also comprising:
- a dividing wall (20) delimiting:
- a cold first thermal zone formed by a first space (E1) situated towards the front part of the enclosure, the said cold zone being intended to receive electrical devices or parts of devices which heat up little if at all, and
- a heating-up second thermal zone formed by a second space (E2) situated towards the rear part of the enclosure, the said hot zone being intended to receive devices or parts of devices which heat up,
- the removable functional units (2a, 2b) form the said dividing wall,
- the electrical enclosure (1) comprises a device for cooling and for regulating the temperature of the first and second spaces E1, E2, **characterized in that** the said device comprising:
- a cooling source (100) positioned only in contact with the first space (E1) in order to cool it;
- heat exchange means (40) allowing cold to pass between the first space (E1) and the second space (E2) in order to cool the heating-up second thermal zone from the cold first thermal zone, the heat exchange means (40) being active and regulated in such a way as to transfer cold according to a fixed ordered temperature into the second space (E2).

2. Electrical enclosure according to Claim 1, **characterized in that** the heat exchange means (40) are positioned on the dividing wall (20).

3. Electrical enclosure according to Claim 1, **characterized in that** the regulated heat exchange means (40) comprise at least one actuator that is controlled and connected to a processing unit, the said actuator being able to cause the air stream to flow from the first space (E1) towards the second space (E2).

4. Electrical enclosure according to any one of the preceding claims, **characterized in that** the cooling source (100) in contact with the first space (E1) is positioned on one face of the electrical enclosure (1).

5. Electrical enclosure according to any one of the preceding claims, **characterized in that** the volume of the first space (E1) is modifiable.

6. Electrical enclosure according to any one of the preceding claims, **characterized in that** it comprises fixing means designed to receive functional electrical units, the said units forming the dividing wall (20).

7. Electrical enclosure according to any one of the preceding claims, **characterized in that** the functional electrical units (2a) each comprise a support supporting several electrical devices (200, 201, 202).

8. Electrical enclosure according to any one of the preceding claims, **characterized in that** a functional electrical unit (2a) comprises an electrical device (201) passing through the dividing wall (20) so as to have a first part situated in the first space (E1) and a second part situated in the second space (E2).

9. Electrical enclosure according to the preceding claim, **characterized in that** the second part of the electrical device (201) comprises a ventilation system in the second space (E2).
